# EUROPEAN PATENT APPLICATION

(11) **EP 2 993 210 A1**
(43) Date of publication of application: **09.03.2016**
(21) Application number: 14382329.2
(22) Date of filing: 03.09.2014
(51) Int. Cl.: C09D 123/04, C09D 123/08, C08L 23/04, C08L 23/08, H01L 31/048

(54) **Encapsulating film for a photovoltaic module**

(71) Applicant: Specialized Technology Resources Espana, S.A., 33428 Llanera (ES)
(72) Inventor: Fidalgo MArtinez, José Ignacio, 33428 Llanera (ES); Merino Martinez, Román, 33428 Llanera (ES)
(74) Representative: ZBM Patents - Zea, Barlocci & Markvardsen

(57) **Abstract**

This invention describes the incorporation of printed conductive elements (2, 3), as conductive tracks for interconnecting photovoltaic cells (4), in a polymeric encapsulating film or layer (1) for photovoltaic modules, the film comprising at least one olefinic co-polymer of ethylene including mono-carboxylic acids, di-carboxylic acids, esters of carboxylic acids (including vinyl esters), alkyl acrylates, alpha-olefins, and combinations thereof.

It also describes methods for making photovoltaic modules that incorporate a polymeric encapsulating film (1) with printed conductive elements (2, 3), as well as the photovoltaic modules themselves.

## Description

### TECHNICAL FIELD OF THE INVENTION

This invention refers to an encapsulating film for a photovoltaic module and to its manufacturing method. It also refers to a photovoltaic module comprising such an encapsulating film, and to its manufacturing method. Particularly, the invention refers to photovoltaic modules with an encapsulating film that comprises a polymeric cross-linkable composition and has built in printed conductive elements which act as conductive tracks, simplifying and optimising the manufacturing process of the module.

### BACKGROUND OF THE INVENTION

Photovoltaic modules are devices that can convert solar energy into electricity. Electrical energy generating devices, such as photovoltaic modules are constructed in a modular, multi-layered format. The top protective cover (i.e., superstrate) of the individual module may be formed from a transparent material such as glass or polymeric material (e.g., fluoropolymer film) which is disposed on the light-receiving side of the photovoltaic module. The photovoltaic-element layer may be formed from a plurality of electrically interconnected solar cells which are embedded between a first transparent encapsulant layer and a second encapsulant layer. (Thin film devices may contain only one layer of encapsulant material). The encapsulant material is designed to protect the fragile solar cells from mechanical damage, such as cracking or breaking; to adhere to both the top protective cover and the photovoltaic-element layer while accommodating stresses created by differences in thermal expansion coefficients between glass and solar cell; and to provide both internal and external electrical isolation to the photovoltaic-element layer. A lower substrate layer, which can be a backing sheet or another glass cover, completes the layered structure of the photovoltaic module.

The current generated by the semiconductor device is extracted through connecting ribbons that electrically link the different active elements that make up the module (called photovoltaic cells), as well as enabling the extraction of current outside the module.

The manufacturing process for photovoltaic modules generally has the following stages:
i) Interconnection of the photovoltaic cells to form strings.
ii) Placement of the front protective layer (superstrate), first transparent encapsulant layer and strings of photovoltaic cells in this order, in the connection table.
iii) Connection of the strings by means of bus bars to form the complete circuit.
iv) Fitting the rear encapsulant layer, backsheet and extraction of terminals;
v) Lamination process using vacuum and heat or other methods
vi) Product framing and fitting the junction box.

Extraction of the electrical energy generated by the photovoltaic elements is done by means of connecting ribbons that are generally soldered to both sides of the photovoltaic cells to connect them together (joining the positive pole of one cell to the negative of the next). These connection ribbons are usually made of copper coated by some sort of soldering alloy. With the increased area of photovoltaic cells and their reduced thickness, this process is critical, as it can generate breakages in the cells, increasing rejects in the production line or micro cracks that can reduce the quality of the final product if they are not detected by means of complex inspection methods.

With the aim of simplifying the manufacture of photovoltaic modules, avoiding the interconnection of cells before the formation of the module and its lamination, some solutions have been put forward, which are described below:

One solution, described in patent WO2012033059, consists in using metal ribbons covered with an electrically conductive adhesive material as connective elements, placed on the metallization mesh of the cell, applying pressure to make the connection. Patent US2012214271 is in the same line, in which metal ribbons are also adhered to the cell by means of an adhesive film. This method avoids the soldering process, but does not improve the productivity of the manufacturing process, as the connective elements must be placed before the lamination of the photovoltaic module and adding more material.

Patent WO2004021455 describes an electrode for cells and photovoltaic modules with the aim of also simplifying the manufacturing process of the photovoltaic modules. The invention refers to an optically transparent layer placed on a layer of adhesive on which are embedded a series of conductive wires, in such a manner that part of the wires project from the adhesive film. These wires can contact the conductive surface of the photovoltaic elements, which can be an electrically conductive transparent layer. Although the manufacturing process is simplified, interconnecting the photovoltaic elements in a single step, the system is complex and requires the use of additional layers of polymeric material in the photovoltaic module, increasing the cost of the system. It is also required that the cells integrate an electrically conductive transparent layer, therefore it is not apt for the majority of existing commercial photovoltaic cells.

Another similar proposal is described in Japanese patent JP2012174724, which refers to an electrode for photovoltaic modules that comprises an insulating layer and conductive material with a similar shape to that of the metal electrodes of the photovoltaic cells. The electrodes can be made of a metal sheet by mechanical or laser cutting and then adhered to the polymeric layer either by applying heat or by the use of an adhesive. This process is complex and difficult to automate in mass production.

Another solution described in patent US2011092014, manages to increase productivity by the use of roll-to-roll printing techniques. The invention is exclusively intended for manufacturing thin film photovoltaic cells with rear contact structure, using a metal substrate as a lower electrode. Contact with the upper electrode is made by means of some orifices in the absorber, which are partially filled with conductive silver ink, which is subsequently irradiated with pulsating light until it fuses with a rear layer of aluminium used as a substrate.

Another solution, described in the family of patents associated to US2011056537, focuses on application in thin film modules with a rear metal substrate, the upper electrode being placed on a flexible film in the front layer. Patent WO2011156397 describes another system in which the conductive tracks are made with a melt flowable electrically conductive thermoplastic adhesive placed on a melt flowable electrically insulating thermoplastic adhesive. Due to the use of two thermoplastic components that flow during lamination (both the insulating and conductive adhesives), the connection of the two patterns of conductive adhesives (front and rear) with the photovoltaic cell and between them has to be done in two different lamination steps.

### DESCRIPTION OF THE INVENTION

According to a first aspect, the present invention relates to an encapsulating film for photovoltaic modules, the film comprising a polymeric cross-linkable composition comprising at least one olefinic co-polymer of ethylene including mono-carboxylic acids, di-carboxylic acids, esters of carboxylic acids (including vinyl esters), alkyl acrylates, alpha-olefins, and combinations thereof, the encapsulating film further comprising at least one electrical conductive element comprising an electrically conductive ink, paint or adhesive in contact with the polymeric cross-linkable composition.

Compared to WO2011/156397, the present invention avoids using expensive thermoplastic materials like fluoropolymers as encapsulants, and enables the manufacturing process of photovoltaic modules with integrated conductive tracks in one single lamination step.

In another aspect, the invention provides a method for manufacturing an encapsulating film for photovoltaic modules, comprising the steps of providing a polymeric cross-linkable composition comprising at least one olefinic co-polymer of ethylene including mono-carboxylic acids, di-carboxylic acids, esters of carboxylic acids (including vinyl esters), alkyl acrylates, alpha-olefins, and combinations thereof, and applying an electrically conductive ink, paint or adhesive on the polymeric cross-linkable composition to form at least one electrical conductive element.

According to further aspects, the invention relates to a photovoltaic module comprising at least one of such encapsulating films, and to a method for manufacturing a photovoltaic module comprising the steps of providing a layer of photovoltaic cells, providing at least one encapsulating film according to the first aspect of the invention, adjacent to the layer of photovoltaic cells and with the electrical conductive elements in contact with the cells, and laminating together at least the photovoltaic cells and the encapsulating film.

### DESCRIPTION OF THE ILLUSTRATIONS

Particular embodiments of the present invention will be described in the following by way of non-limiting examples, with reference to the appended drawings, in which:
Figure 1. Plan view of an embodiment of a polymeric encapsulating film (1) incorporating printed conductive tracks as bus bars (2) for the connection of soldered photovoltaic cell strings.
Figure 2. Plan view of an embodiment of a polymeric encapsulating film (1) incorporating printed conductive tracks (3) for interconnection of the photovoltaic cells.
Figure 3. Plan view of an embodiment of a polymeric encapsulating film (1) incorporating printed conductive elements used as bus bars (2) and printed conductive tracks (3) for interconnection of the photovoltaic cells.
Figure 4. Rear plan view showing the solar photovoltaic cells (4), with a rear contact (back contact cells with both positive and negative contacts on the same side), including soldered ribbons (9) for interconnecting the photovoltaic cells (4), according to the prior art.

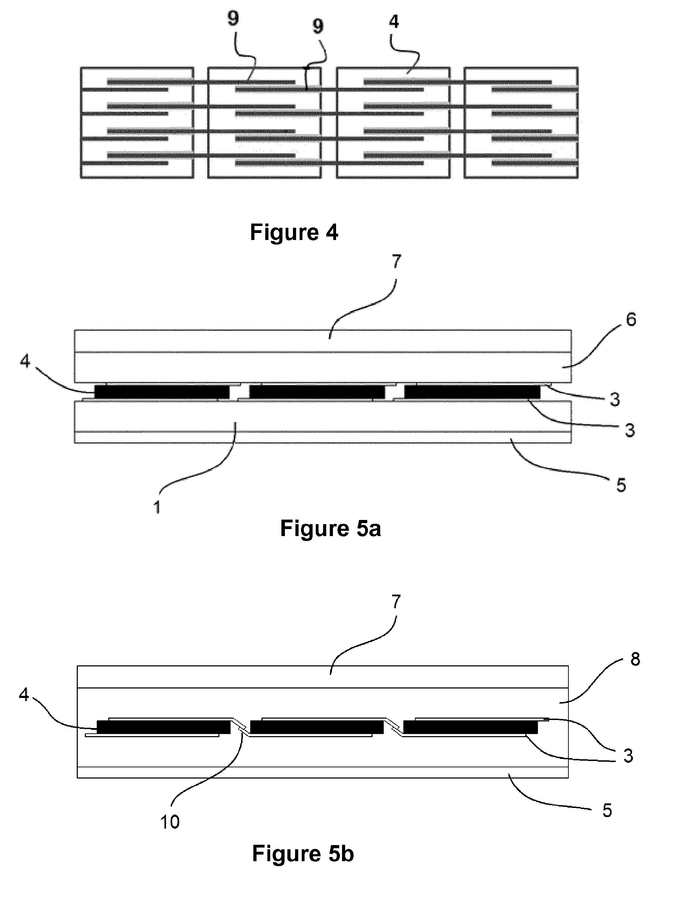

Figures 5a and 5b. Section of an embodiment of a photovoltaic module before and after lamination thereof, comprising in Figure 5a, from bottom to top, the following elements: substrate or backsheet (5), lower polymeric encapsulating film (1) with printed conductive tracks (3) for interconnecting the photovoltaic cells, photovoltaic solar cells (4), upper polymeric encapsulating film (6) with printed conductive tracks (3) for interconnecting the photovoltaic cells (4), upper glass (7) sealing the whole system. Instead of the two encapsulating films (1 & 6), Figure 5b shows a layer of cross-linked encapsulant (8) resulting from the lamination, and the area of interconnection (10) of the conductive tracks (3) within the encapsulant (8).

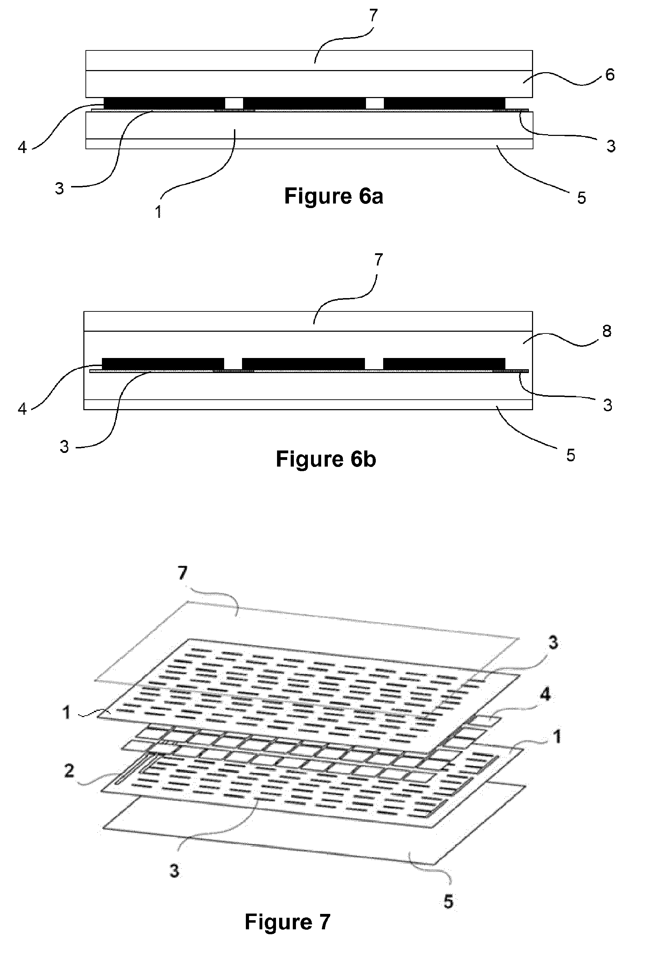

Figures 6a and 6b. Section of an embodiment of a rear contact photovoltaic module before and after lamination thereof, comprising, from bottom to top, the following elements: substrate or backsheet (5), lower polymeric encapsulating film (1) incorporating printed conductive tracks (3) for interconnecting the photovoltaic cells, back contact solar cells (4), upper polymeric encapsulating film (6) without printed conductive tracks, upper glass (7) sealing the whole system. Instead of the two encapsulating films (1 & 6), Figure 6b shows a layer of cross-linked encapsulant (8) resulting from the lamination.
Figure 7. Breakdown, in layers, of an embodiment of a photovoltaic module in which the encapsulating film incorporates conductive elements of different types, comprising: substrate or backsheet (5), polymeric encapsulating film (1) incorporating printed conductive elements (3) for interconnecting photovoltaic cells and printed conductive tracks as bus bars (2), solar cells (4), polymeric encapsulating film (1) with printed conductive tracks (3) for interconnecting photovoltaic cells and an upper glass (7) sealing the whole system.
Figure 8. Diagram of the assembly of a photovoltaic module in which the conductive tracks are not incorporated into the polymeric encapsulating film (prior art).
Figure 9. Diagram of the assembly of an embodiment of a photovoltaic module in which the conductive tracks are printed on the polymeric encapsulating film.

### DESCRIPTION OF EMBODIMENTS OF THE INVENTION

Embodiments of the present invention are related to a polymeric encapsulating film for photovoltaic modules that integrates conductive tracks placed on the same by printing techniques, in such a manner that the interconnection of cells and manufacturing of the photovoltaic module is done in a single step. In this manner, the manufacturing process of photovoltaic modules is simplified and productivity is increased. The invention also refers to the module incorporating this encapsulant, as well as its manufacturing process.

The electrically conductive elements soldered to both sides of the photovoltaic cells to extract the current generated by the cells (connection ribbons) are replaced by printed conductive tracks on the encapsulant, which will interconnect the cells, and/or act as bus bars between the strings of cells, and lead the current to the point of extraction of terminals. These conductive tracks may have characteristics that enable the extraction of energy from the modules, allow the interconnection between cells and possess physical characteristics that enable them to retain their properties after the lamination process and during operation of the photovoltaic module in its service life.

These conductive tracks can be used to connect the photovoltaic devices of different technologies based on different semiconductors: amorphous silicon, CdTe, CIGS or other thin film technologies, or crystalline silicon or other wafer-based technologies that may include opposite polarity contacts on each side of the device, or with both positive and negative contacts on the same side of the cell. Depending on the different materialisations, this invention can be adapted to each type of configuration of the photovoltaic device.

Encapsulating films according to embodiments of the invention comprise at least one electrical conductive element applied on an extruded layer of a polymeric cross-linkable composition comprising at least one olefinic co-polymer of ethylene including mono-carboxylic acids, di-carboxylic acids, esters of carboxylic acids (including vinyl esters), alkyl acrylates, alpha-olefins, and combinations thereof. The electrical conductive elements may comprise electrically conductive ink, paint or adhesive, and is in contact with the polymeric cross-linkable composition.

In one or more embodiments of the present invention, the at least one olefinic copolymer is preferably an ethylene-based co-polymer with one or more co-monomers characterized by ethylene content greater than 40 percent (%), preferably from 45% to 98%, and more preferably from 50% to 95%. Co-monomers suitable for use in olefinic co-polymers of the present invention may include mono- or di-carboxylic acids, vinyl esters of carboxylic acids, alkyl acrylates, alpha-olefins, or combinations thereof.

In one or more embodiments, the at least one olefinic co-polymer of the present invention may be one or more ethylene co-polymers containing at least one mono- or dicarboxylic acid co-monomer. Suitable mono- or di-carboxylic acid co-monomers include acrylic, methacrylic, ethacrylic, itaconic, maleic, fumaric, crotonic, cinnamic, or combinations thereof. In addition, one or more alkyl acrylate co-monomers, such as acrylate, methylacrylate, methyl-methacrylate, butylacrylate, isobutylacrylate, or combinations thereof, may be included in the co-polymer of the present invention. Ethylene mono- or di-carboxylic acid co-polymers include, but are not limited to, ethylene / acrylic acid, ethylene / methacrylic acid, ethylene / acrylic acid / methylacrylate, ethylene / acrylic acid / n-butylacrylate, ethylene / acrylic acid / isobutylacrylate, ethylene / acrylic acid / n- butylmethacrylate, ethylene / acrylic acid / methylmethacrylate, ethylene / methacrylic acid / methylacrylate, ethylene / methacrylic acid / n-butylmethacrylate, ethylene / methacrylic acid / isobutylacrylate, ethylene / methacrylic acid / methyl methacrylate, or combinations thereof. Exemplary ethylene mono- or di-carboxylic acid co-polymers are commercially available as Nucrel^{®} from Du Pont de Nemours & Co., in Wilmington, Del.; as Excor^{®} from ExxonMobil Chemical Co., in Huston, Tex.; and as Primacor^{®} from Dow Chemical Co. in Midland, Mich.

In one or more embodiments, the at least one olefinic co-polymer of the present invention may be one or more ethylene vinyl ester co-polymers which are radically, or high pressured polymerized to obtain vinyl ester content from 10% to 45%, preferably from 15% to 40%. Ethylene vinyl ester co-polymers include, but are not limited to, ethylene vinylformate, ethylene vinylacetate, ethylene vinyl propionate, ethylene vinylisopropionate, ethylene vinylbutyrate, ethylene vinylhexonoate, or combinations thereof. Ethylene vinylacetate is preferred. The ethylene vinyl ester co-polymer typically has a melt flow rate (as determined by ASTM D1238-10) at a temperature of 190°C and at a load of 2.16 kg ranging from about 0.01 dg/min to about 120 dg/min, preferably from about 0.1 dg/min to about 100 dg/min, and more preferably from about 1 dg/min to about 80 dg/min. The ethylene vinyl ester co-polymer is preferably further characterized by a density typically ranging from about 0.89 g/cm³ to about 1.25 g/cm³, preferably from about 0.905 g/cm³ to about 1.05 g/cm³, and more preferably from about 0.91 g/cm³ to about 0.99 g/cm³. Exemplary ethylene vinyl ester co-polymers are commercially available as Evatane^{®} from Arkema, Inc., in Philadelphia, Penn.; as Elvax^{®} from Du Pont de Nemours & Co., in Wilmington, Del.; as Escorene^{®} from ExxonMobil Chemical Co., in Huston, Tex.; as Ateva^{®} from Celanese EVA Performance Polymers, in Edmonton, Canada; and as Alcudia^{®} from Repsol Química S.A., Madrid, Spain.

In one or more embodiments, the at least one olefinic co-polymer of the present invention may be ethylene alkyl acrylate co-polymers which are radically, or high-pressured polymerized to obtain alkyl acrylate content from 10% to 45%, preferably from 15% to 40%. Alkyl acrylates suitable for use in the co-polymer of the present invention include C1-C8 alkyl esters of acrylic acid, for example, the methyl, ethyl, butyl, isobutyl, hexyl, and 2-ethylhexyl esters. Ethylene alkyl acrylate co-polymers include, but are not limited to, ethylene methylacrylate, ethylene ethylacrylate, ethylene butylacrylate, ethylene methylmethacrylate, ethylene ethylmethacrylate, or combinations thereof. Ethylene co-polymers with methyl (meth)acrylate, ethyl (meth)acrylate, and butyl (meth)acrylate are preferred. As used herein, the term "(meth)acrylate" refers to either methacrylate or acrylate. The ethylene alkyl acrylate co-polymer typically has a melt flow rate (as determined by ASTM D1238-10) at a temperature of 190°C and at a load of 2.16 Kg ranging from about 0.01 dg/min to about 100 dg/min, preferably from about 0.1 dg/min to about 75 dg/min, and more preferably from about 1 dg/min to about 50 dg/min. The ethylene alkyl acrylate co-polymer is preferably further characterized by a density typically ranging from about 0.88 g/cm³ to about 1.05 g/cm³, preferably from about 0.905 g/cm³ to about 0.98 g/cm³, and more preferably from about 0.91 g/cm³ to about 0.97 g/cm³. Exemplary ethylene alkyl co-polymers are commercially available as Elvaloy^{®} from Du Pont de Nemours & Co., in Wilmington, Del.; as Optema^{®} from ExxonMobil Chemical Co., in Huston, Tex.; As Lotryl^{®} from Arkema Inc., in Philadelphia, Penn; EMAC^{®} and EBAC from Westlake Chemicals, in Longview, Tex.; as Amplify^{®} from Dow Chemical Co., in Midland, Mich.; and as Alcudia^{®} from Repsol Química, S.A. in Madrid, Spain.

In one or more embodiments, the at least one olefinic co-polymer of the present invention may be ethylene alpha-olefin co-polymers which are catalyzed via metallocene, or single site, catalysis to obtain alpha-olefin content from 1% to 50%, preferably from 3% to 45%. Alpha-olefin co-monomers suitable for use in the co-polymer of the present invention include any C3 to C20 olefin, with propylene, 1-butene, 1-hexene, 1-octene, or 4-methyl-1-pentene being most preferred. The alpha-olefin co-monomers may be linear or branched, and two or more comonomers may be used, if desired. The metallocene catalyzed ethylene alpha-olefin co-polymer typically has a melt flow rate (as determined by ASTM D1238-10) at a temperature of 190°C and at a load of 2.16 Kg ranging from about 0.001 dg/min to about 120 dg/min, preferably from about 0.05 dg/min to about 100 dg/min, and more preferably from about 1 dg/min to about 50 dg/min. The metallocene-catalyzed ethylene alpha-olefin co-polymer is preferably further characterized by a density typically ranging from about 0.84 g/cm³ to about 1.05 g/cm³, preferably from about 0.845 g/cm³ to about 0.98 g/cm³, and more preferably from about 0.85 g/cm³ to about 0.95 g/cm³. Exemplary ethylene alpha-olefin co-polymers are commercially available as Engage^{®}, Versify^{®}, or Affinity^{®} from Dow Chemical Co., in Midland, Mich.; as Exact^{®} or Exceed^{®} from ExxonMobil Chemical Co., in Huston, Tex.; and as Tafmer^{®} from Mitsui Chemical Inc., in Tokyo, Japan.

In one or more embodiments, the at least one olefinic co-polymer of the present invention may be blended with a second polymeric component. As used herein, the term "blended" refers to either an in-situ reactor-made blend (i.e., using a series of reactors while polymerization is occurring), a physical blend (i.e., using internal mixers, static mixers, impingement mixers, solution blending, melt blending with single or twin screw extruders, lateral 2-roll mixers, etc.), or combinations thereof. The second polymeric component may be one or more cycloolefin co-polymers which are prepared with the aid of transition-metal catalysts by co-polymerizing cycloolefin homopolymers with additional co-monomers. Cycloolefins are mono or polyunsaturated polycyclic ring systems, such as cycloalkenes, bicycloalkenes, tricycloalkenes, or tetracycloalkenes. The ring systems can be monosubstituted or polysubstituted. Preference is given to the cycloolefins which are built up from monoalkylated or unsubstituted cycloolefins. Particularly preferred cycloolefin homopolymers are polynorbornene, polycyclopentene, polydimethyloctahydronaphthalene, and poly(5-methyl)norbornene. In a preferred embodiment, cycloolefin co-polymers contain up to 30%, preferably 1 % to 25% of co-monomer. Preferred comonomers are olefins having 2 to 6 carbon atoms, in particular ethylene, butylene, or combinations thereof. Preferred cycloolefin co-polymers of the invention are ethylene-norbornene co-polymers. The cycloolefin co-polymer typically has a melt flow rate (as determined by ASTM D1238-10) at a temperature of 260°C and at a load of 2.16 Kg ranging from about 0.01 dg/min to about 105 dg/min, preferably from about 0.1 dg/min to about 95 dg/min, and more preferably from about 1 dg/min to about 80 dg/min. The cycloolefin co-polymer is preferably further characterized by a density typically ranging from about 0.905 g/cm³ to about 1.35 g/cm³, preferably from about 0.95 g/cm³ to about 1.25 g/cm³, and more preferably from about 0.97 g/cm³ to about 1.20 g/cm³. The preferred cycloolefin co-polymer of the present invention has a Tg equal to or greater than 40°C, preferably from 55°C to 300°C, Exemplary cycloolefin co-polymers are commercially available as Topas^{®} from Topas Advanced Polymers GmbH, in Frankfurt, Germany; as Zeonex^{®} or Zeonor^{®} from Zeon Chemicals, in Tokio, Japan; and as Apel^{®} from Mitsui Chemical Inc., in Tokyo Japan.

The expression "polymeric cross-linkable composition" stands herein for a blend that is able to cure by polymer cross-linking to develop a mechanically stable thermoset material. Curing of the polymeric cross-linkable composition is typically performed during lamination, a process that involves vacuum and heat, at temperatures typically around 140°C or above, and up to 5-30 minutes cycle time per unit or batch. The cross-linkable composition may comprise also suitable curing agents, to promote the curing of the polymeric cross-linkable composition to get a thermoset material. Suitable curing agents useful in the present invention include, but are not limited to, phenolic resins, organic peroxides, maleimides, sulfur-containing curatives, and silicon-containing curatives.

The purpose of the curing agent is to cross-link the polymer during the lamination procedure, thus providing a thermoset material which is mechanically stable at typical operating temperatures. The degree of chemical cross-linking of the cured encapsulant, generally referred to as "gel content" (insoluble fraction), is expressed as the fraction (percentage) of the polymer that cannot be extracted using a suitable solvent, such as decahydronaphthalene, xylenes, toluene or tetrahydrofuran. Determination of gel content can be carried out by conventional procedures known in the art.

To provide sufficient mechanical strength to support the solar cells in a photovoltaic module, the gel content of the encapsulant should preferably be at least 70%. The requisite gel content may be achieved during the lamination and curing cycles of the photovoltaic module processing, typically by adjusting time and temperature conditions during the lamination procedure. Radical-producing curing agents such as organic peroxides having a decomposition half-life of less than about one hour at 140 °C are preferred. Half life is defined as the time required, at a specific temperature, to reduce the original peroxide concentration by half. The requisite gel content may also be achieved by causing cross-linking of the polymeric composition during the manufacture of the encapsulating film, before it is laminated with other components in the manufacture of a photovoltaic module.

The conductive ink, paint or adhesive of the conductive elements or tracks may also be cured during the manufacture of the encapsulating film, or during lamination of the photovoltaic module.

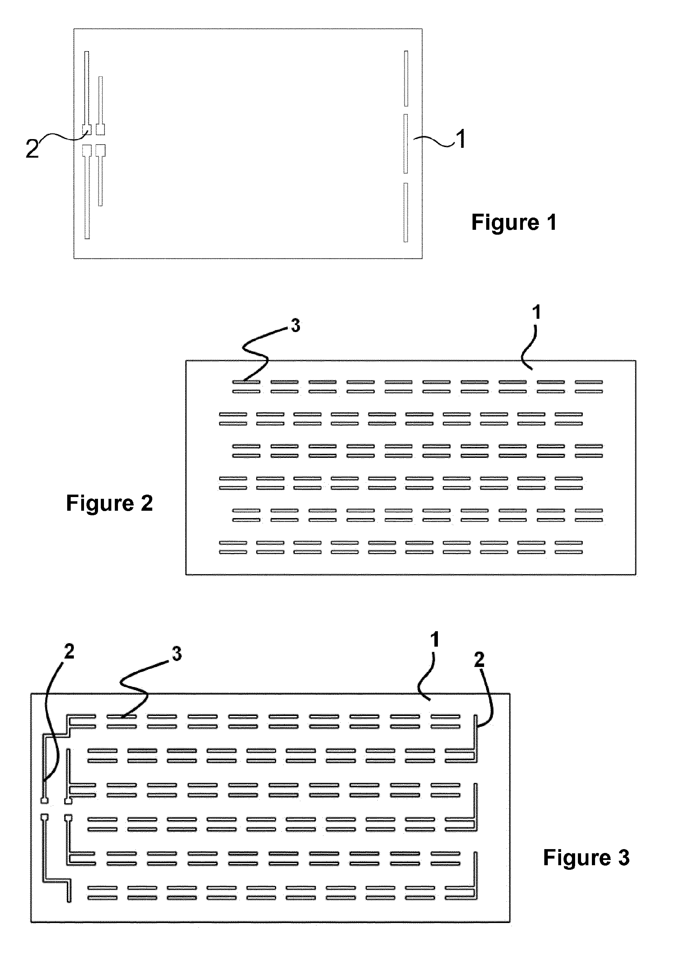

Examples of such encapsulating films (1) with electrical conductive elements (3) may be as shown in Figures 1 to 3. As shown, the electrical conductive elements may comprise:
i) A plurality of conductive tracks printed on the polymeric layer, designed in such a way that they coincide with the metallic positive and negative contacts of the photovoltaic cells in the photovoltaic module (as in Figures 2and 3) and/or
ii) Printed bus bars to connect strings of cells together, and lead the electrical current to the point where it is extracted from the terminals of the module (as in Figures 1 and 3).

The conductive tracks and bus bars are formed with printing technologies with highly conductive inks using silk screen printing, rotogravure, flexography, injection printing or others, that can be carried out continuously in roll-to-roll lines or in a process by batches. The inks used to make the conductive tracks are composed, among other components, of electrically conductive particles. These particles can be Ag, Cu (micro or nanometric in size), carbon nanotubes or other conductive elements. Ink conductivity varies according to the type of elements it is made of, their concentration, distribution of particles, etc., with conductivities ranging from 10⁻⁸ S·m⁻¹ to 6.30 × 10⁷ S·m⁻¹.

The drying or curing process of the conductive inks can be carried out by heat, ultraviolet light or any other sintering or curing technique required by the ink.

The layout of the conductive tracks and bus bars on the polymeric encapsulant can be done by any printing technique considered adequate, such as the following:
- Silk screen printing is a technique used in the reproduction method of documents and images on any material, and consists in transferring the ink through a mesh tensioned in a frame. Passage of ink is blocked in areas where there will be no image by means of an emulsion or varnish. The mesh is free of emulsion or varnish in areas where the ink is to pass free.
- Rotogravure is a printing technique in which the images are transferred to the substrate from a surface with depressions that contain ink. This printing system offers good results for printing on flexible high quality elements.
- Flexography, a printing technique in relief, in which the printed areas of the shape are higher than the non-printed areas. This printing system uses liquid inks characterised by their quick drying properties.
- Ink injection is a printing method where there is no contact between the print head and the substrate. The printing head moves, using different systems, over the surface of the substrate and deposits droplets of ink in the desired positions to make the required design.

Another aspect of the invention refers to the photovoltaic module comprising an encapsulating layer with built in conductive tracks, comprising, as shown in Figures 5 to 7: photovoltaic cells (4) that capture solar radiation and convert it into electricity, containing metal contacts with opposite polarity, either on the same side or opposite sides, at least one sheet or film (1, 6) of encapsulant polymeric material with conductive tracks (3), which may include bus bars (2), made by printing, a front and rear cover (7, 5) that provide mechanical stability and optionally other possible elements such as a junction box, connection cables and a frame.

The upper protective layer (7) provides impact protection as well as weather protection to the photovoltaic module. The upper protective layer is advantageously formed from glass, preferably tempered, patterned, or both, such as Solite^{®} patterned glass, commercially available from AGC Solar, in Brussels, Belgium. Fluorinated polymers which are formed into thin films in a suitable thickness may also be used as the upper protective layer(s). Exemplary fluorinated polymers are commercially available as Teflon^{®} or Tefzel^{®} from Du Pont de Nemours & Co., in Wilmington, Del.; as Kynar^{®} from Arkema Inc., in Philadelphia, Penn.; and as Fluon^{®} from Asahi Glass Co., in Tokyo, Japan. The upper protective (7) layer may have a thickness equal to or greater than 0.25 millimetre (mm). Thus, the solar cells (4) in the middle photovoltaic-element layer are exposed to direct sunlight without being exposed to moisture and other climatic conditions and without being exposed to direct impact by falling objects and debris. The lower substrate layer (5) is typically formed from glass or a layered polymeric construct. The layered polymeric structure typically has an outermost layer formed from fluoropolymer film such as Tedlar^{®}, commercially available from Du Pont de Nemours & Co., in Wilmington, Del.; as Hylar^{®}, commercially available from Solvay Solexis, in Bollate, Italy; as Aclar^{®}, commercially available from Arkema Inc., in Philadelphia, Penn.; and/or as fibre reinforced plastic, such as polyester resin embedded with stranded glass fibres. The lower substrate layer (5) provides an advantageous combination of stiffness, light weight, very low permeability, electrical isolation and flatness.

Preferably, a lower encapsulating layer or film (1) is provided as a thin film having a thickness typically between 0.05 to 2.5 mm, preferably between 0.05 to 1.3 mm, or more preferably between 0.1 to 1.1 mm that is positioned on the upper surface of the lower substrate layer (5). The array of solar cells (4) in the middle photovoltaic-element layer is then positioned on the lower encapsulating film (1). An upper encapsulating layer or film (6) is placed over the middle photovoltaic-element layer so that the solar cells (4) are sandwiched between the two encapsulating films or layers (1, 6). The transparent upper protective layer (7) is then positioned over the upper transparent encapsulating film (6) to complete the laminated structure. Lamination is generally defined as the process of bonding together two or more prefabricated sheets or film layers by the use of adhesives, or by a combination of heat and pressure (i.e., melt-pressing). The polymeric encapsulant acts as a binder to secure the solar cells (4) between the upper protective layer (7) and the lower substrate layer (5) and as a cushion between the two outer layers.

Another aspect of the invention refers to the manufacturing process of the aforementioned photovoltaic module.

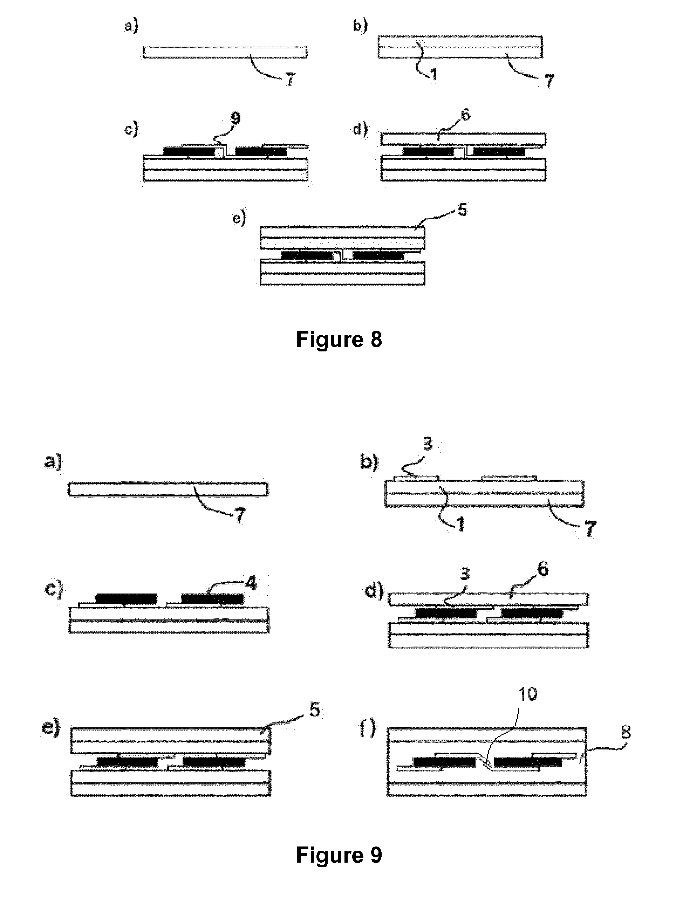

In the prior art, such as shown in Figure 8, a photovoltaic module is assembled following these steps:
a) Placement of the upper glass (7).
b) Placement of the upper polymeric encapsulant (1).
c) Placement of a string of photovoltaic cells (9). These were soldered in a previous stage.
d) Lower polymeric encapsulant (6)
e) Placement of the substrate or backsheet (5).

In embodiments of the invention, a photovoltaic module is assembled following these steps, such as shown in Figure 9:
a) Upper glass (5).
b) Upper polymeric encapsulating film or layer (1) incorporating printed conductive tracks (3) for interconnection of the photovoltaic cells (4).
c) Placement of the solar cells (4)
d) Lower polymeric encapsulating film or layer (6) incorporating printed conductive tracks (3) for interconnection of the photovoltaic cells (4).
e) Substrate or backsheet (7).
f) Lamination of the assembly, in which the two encapsulating films (1 & 6) form a cross-linked encapsulant layer (8), and the printed conductive tracks (3) become joined to each other at an interconnection area (10) within this layer (8).

In the above case, the conductive tracks (3) are printed or otherwise applied on the encapsulating film in a separate process, prior to the assembly of the photovoltaic module. The encapsulating film with conductive tracks may be manufactured and stored (for example in rolls), and then for example cut to size for a photovoltaic module.

In alternative embodiments, a photovoltaic module is assembled with the following steps:
i) Printing of the conductive tracks on at least one layer or film of the polymeric encapsulant.
ii) Placement of the optically transparent polymeric encapsulating film, which may or may not contain built in conductive tracks, over a protective front cover (superstrate). This can optionally be done before the printing.
iii) Placement of the photovoltaic cells on the front polymeric encapsulating layer or film. If the front encapsulating layer has built in conductive tracks, the metal contacts of the cells will be placed exactly on the built in conductive tracks designed to coincide, before the ink has cured, so the contact resistance between the metal contacts and the tracks is minimal.
iv) Placement of at least a second encapsulating film or layer behind the cells, with built in conductive tracks. The conductive tracks built into the rear encapsulant may be larger than the rear contacts of the cells, to improve the extraction of current.
v) Placement of a second external layer (substrate or backsheet).
vi) Lamination of the photovoltaic module, which at the same time cures the conductive ink.
vii) Integration of auxiliary elements.

In another embodiment of the invention a manufacturing process of the photovoltaic module may have the following steps:
i) Printing of conductive ink to form conductive tracks on at least one layer of polymeric encapsulant and curing of the ink by heat, ultraviolet radiation or other sintering technique.
ii) Placement of the optically transparent polymeric encapsulant, which may or may not contain built in conductive tracks, over a protective front cover (superstrate).
iii) If the front encapsulant layer has built in conductive tracks, the metal contacts of the cells are placed exactly on the built in conductive tracks, which have been designed for this purpose.
iv) Placement of at least a second encapsulant layer behind the cells, with built in conductive tracks.
v) Placement of a second external layer (substrate or backsheet).
vi) Lamination of the photovoltaic layer in which the electrical contact between the conductive tracks and the electric contacts of the cells is produced by pressure.
vii) Integration of auxiliary elements.

Another embodiment of the invention refers to a possible improvement in the described manufacturing process whereby an intermediate stage is included in which conductive adhesive or solder alloy is added to reduce the contact resistance between the conductive tracks and the electrical contacts of the photovoltaic cells.

A further possible embodiment of the invention contemplates an extruded film or layer of polymeric encapsulant (1) with printed conductive elements that have different functions.

Another possible embodiment of the invention, defines a photovoltaic module that comprises, among other elements, a first extruded layer or film of polymeric encapsulant (1) containing several printed conductive elements such as conductive tracks (3) for interconnecting the photovoltaic cells (4) and conductive tracks as bus bars (2) for extracting the current from the photovoltaic module. The conductive tracks (3) are designed to interconnect the photovoltaic cells (4) coinciding with the positive metal contacts of the photovoltaic cells (4) in the module and extend beyond the surface of the cell to the interconnection zone. The photovoltaic module may have a second extruded polymeric encapsulant layer or film (1), located over the photovoltaic cells (4), with printed conductive tracks (3) for interconnecting photovoltaic cells (4) designed to coincide with the negative metal contacts of the photovoltaic cells (4) that form the module and extend beyond the surface of the cell to connect to the tracks of the first string in the interconnection area. After lamination, there is a physical contact between the conductive tracks of the upper and lower encapsulating films or layers in the interconnection zone. This contact closes the circuit and allows for the extraction of the current from the module.

Another possible embodiment of the system comprises an extruded polymeric encapsulant layer or film (1) containing multiple printed conductive tracks (3) for interconnecting photovoltaic cells (4) designed to coincide with the positive and negative metal contacts of the photovoltaic cells (4), in this case of rear contact, built into the module enabling interconnection of the positive contact of one cell (4) to the negative contact of the neighbouring cell (4), and at least a second extruded layer or film of polymeric encapsulant that does not contain printed conductive tracks.

## Claims

1. Encapsulating film for photovoltaic modules, the film comprising a polymeric cross-linkable composition comprising at least one olefinic co-polymer of ethylene including mono-carboxylic acids, di-carboxylic acids, esters of carboxylic acids (including vinyl esters), alkyl acrylates, alpha-olefins, and combinations thereof, the encapsulating film further comprising at least one electrical conductive element comprising electrically conductive ink, paint or adhesive in contact with the polymeric cross-linkable composition.

2. Encapsulating film according to claim 1, wherein the at least one olefinic copolymer of ethylene is selected from the group consisting of ethyl butyl acrylate (EBA), ethyl methyl acrylate (EMA), ethyl hexyl acrylate (EHA), ethyl methyl methacrylate (EMMA), and combinations thereof.

3. Encapsulating film according to any of claims 1 or 2, wherein the cross-linkable composition further comprises a curing agent

4. Encapsulating film according to any of claims 1 to 3, wherein the cross-linkable composition further comprises one or more substance selected from colorants, pigments, mineral fillers, metal oxides, curing co-agents, adhesion promoters, thermal stabilizers, ultra-violet light stabilizers, antioxidants, processing aids, plasticizers, flame retardants, reinforcing agents, anti-static agents, dispersants, or combinations thereof.

5. Encapsulating film according to any of claims 1 to 4, wherein the electrical conductive elements form bus bars (2) for connection to strings (9) of photovoltaic cells (4) of a photovoltaic module.

6. Encapsulating film according to any of claims 1 to 5, wherein the electrical conductive elements form conductive tracks (3) for interconnecting photovoltaic cells (4) of a photovoltaic module.

7. Encapsulating film according to any of claims 1 to 6 wherein the electrical conductive elements comprise an electrical conductive ink, paint or adhesive with a range of conductivity between 10⁻⁸ S·m⁻¹ and 6.30 × 10⁷ S·m⁻¹.

8. Encapsulating film according to any one of claims 1 to 7 wherein the electrical conductive elements are arranged in the film forming patterns suitable for conducting electrical energy from the photovoltaic cells to the module terminals of a photovoltaic module.

9. Photovoltaic module comprising at least one encapsulating film according to any one of claims 1 to 8.

10. Photovoltaic module according to claim 9, comprising a plurality of strings (9) of photovoltaic cells (4) and two encapsulating films according to any one of claims 1 to 8, one on each side of the strings (9) of photovoltaic cells (4).

11. Method for manufacturing an encapsulating film for photovoltaic modules, comprising the following steps:
providing at least one olefinic co-polymer of ethylene including mono-carboxylic acids, di-carboxylic acids, esters of carboxylic acids (including vinyl esters), alkyl acrylates, alpha-olefins, and combinations thereof, and applying electrically conductive ink, paint or adhesive on the polymeric cross-linkable composition to form at least one electrical conductive element.

12. Method according to claim 11, further comprising causing cross-linking of the polymeric cross-linkable composition of the encapsulating film.

13. Method according to any of claims 11 or 12, further comprising causing curing of the electrically conductive ink, paint or adhesive of the electrical conductive elements.

14. Method for manufacturing a photovoltaic module, comprising the following steps:
providing a layer of photovoltaic cells,
providing at least one encapsulating film according to any of claims 1 to 8, adjacent to the layer of photovoltaic cells and with the electrical conductive elements in contact with the cells, and
laminating together at least the photovoltaic cells and the encapsulating film.

15. Method according to claim 14, wherein the step of laminating together the photovoltaic cells and the encapsulating film comprises causing cross-linking of the polymeric cross-linkable composition of the encapsulating film.

16. Method according to any of claims 14 or 15, wherein the step of laminating together the photovoltaic cells and the encapsulating film comprises causing curing of the electrically conductive ink, paint or adhesive of the electrical conductive elements.
